# EUROPÄISCHE PATENTSCHRIFT

(11) **EP 2 291 890 B1**
(45) Veröffentlichungstag und Bekanntmachung des Hinweises auf die Patenterteilung: **28.11.2012**
(21) Anmeldenummer: 09757117.8
(22) Anmeldetag: 02.06.2009
(51) Int. Cl.: H01S 5/024, H01S 5/40

(54) **WÄRMEÜBERTRAGUNGSVORRICHTUNG MIT WENIGSTENS EINEM HALBLEITERBAUELEMENT, INSBESONDERE EINEM LASER- ODER LEUCHTDIODENELEMENT, UND VERFAHREN ZU SEINER MONTAGE**
HEAT TRANSFER DEVICE HAVING AT LEAST ONE SEMICONDUCTOR ELEMENT, PARTICULARLY A LASER OR LIGHT-EMITTING DIODE ELEMENT, AND METHOD FOR THE ASSEMBLY THEREOF
DISPOSITIF DE TRANSMISSION DE CHALEUR PRÉSENTANT AU MOINS UN COMPOSANT SEMI-CONDUCTEUR, EN PARTICULIER UN ÉLÉMENT À DIODE LASER OU À DIODE ÉLECTROLUMINESCENTE, ET PROCÉDÉ DE MONTAGE DE CE DISPOSITIF

(30) Priorität: 02.06.2008 DE 102008026801
(43) Veröffentlichungstag der Anmeldung: 09.03.2011
(73) Patentinhaber: JENOPTIK LASER GMBH, D-07745 Jena (DE)
(72) Erfinder: SCHRÖDER, Matthias, 07646 Stadtroda (DE); LORENZEN, Dirk, D-16798 Fürstenberg (DE)
(74) Vertreter: Geyer, Fehners & Partner
(86) Internationale Anmeldenummer: PCT/DE2009/000770
(87) Internationale Veröffentlichungsnummer: WO 2009/146683

(56) Entgegenhaltungen:
- WO-A1-2008/027133
- JP-A- 2003 037 325
- US-A- 5 325 384
- D LORENZEN ET AL: "Passively cooled diode lasers in the CW power range of 120-200W" PROCEEDINGS OF THE SPIE, Bd. 6876, Nr. 68760Q, 1. Februar 2008 (2008-02-01), Seiten 68760Q-1-68760Q-12, XP002587145 in der Anmeldung erwähnt

## Beschreibung

Diese Patentanmeldung beansprucht die Priorität der deutschen Patentanmeldung 10 2008 026 801.1 deren Offenbarungsgehalt hiermit durch Rückbezug aufgenommen wird.

Die Erfindung betrifft eine Wärmeübertragungsvorrichtung mit wenigstens einem Halbleiterbauelement, insbesondere einem Laser- oder Leuchtdiodenelement, nach dem Oberbegriff des Anspruches 1 und ein Verfahren zu seiner Montage.

### Stand der Technik

Zur Verringerung des thermischen Widerstandes von Wärmeübertragungsvorrichtungen, die die Kühlung von Laserdiodenbarren unterstützen, ist es beispielsweise aus den Patent- und Offenlegungsschriften US 5,325,384, WO 2006 098 897 A1 und WO 2007 082 508 A1 bekannt, Wärmeleitkörper auf einander gegenüberliegenden Seiten des Laserbarrens anzubringen. Ist das Wärmeabfuhrvermögen der Wärmeleitkörper unterschiedlich - beispielsweise, weil die an die Wärmeleitkörper angeschlossenen Wärmesenken einen deutlich voneinander abweichenden thermischen Widerstand aufweisen, so kann der thermische Widerstand der Wärmeübertragungsvorrichtung dadurch verringert werden, dass beide Wärmeleitkörper in Wärmetransferabschnitten abseits des Laserdiodenbarrens miteinander in thermische Verbindung gebracht werden, so dass ein Teil der Wärme des schlechter gekühlten Wärmeleitkörpers vom besser gekühlten aufgenommen werden kann. Im Extremfall ist nur einer der Wärmeleitkörper an eine Wärmesenke angeschlossen und muss die vom anderen Wärmeleitkörper aufgenommene Wärme des Laserdiodenbarrens im wesentlichen vollständig aufnehmen. Eine derartige Anordnung ist aus der Veröffentlichung Nr. 68760Q der Proc. SPIE Vol. 6876 des Jahres 2008 bekannt, in der zur Erzielung einer guten thermischen Verbindung zwischen den Wärmeleitkörpem eine thermisch hoch leitfähige elektrisch isolierende Aluminiumnitrid-Keramikplatte mit Hilfe zweier metallischer Lotschichten, auf der dem Lichtaustritt abgewandten Seite des Laserdiodenbarrens zwischen den epitaxieseitigen metallischen Wärmeabfuhrkörper und den substratseitigen metallischen Wärmeleitkörper gelötet wurde.

Bei dieser und ähnlichen Anordnungen besteht das Problem, dass das hoch wärmeleitfähige Zwischenelement, dass zwischen den Wärmetransferabschnitten der Wärmeleitkörper angeordnet ist vorzugsweise dieselbe Dicke aufweisen sollte wie der Laserdiodenbarren zwischen seinen beiden zur Wärmeableitung von Wärmeaufnahmeabschnitten der Wärmeleitkörper kontaktierten Seiten, damit die Dicke der Fügezonen zwischen dem Laserbarren und den Wärmeaufnahmeabschnitten der Wärmeleitkörper einerseits und zwischen dem Zwischenelement und den Wärmetransferabschnitten der Wärmeleitkörper andererseits einerseits gleich und andererseits über die Ausdehnung jeder Fügezone konstant gehalten werden kann.

Eine konstante, gleichbleibende und insbesondere geringe Fügezonendicke ist insbesondere für die Kontaktierung des Laserdiodenbarrens unerlässlich, um eine gleichbleibende Qualität und Zuverlässigkeit des sowohl thermisch als auch elektrisch und optisch hoch belasteten Diodenlasers zu sichern.

Nun ist die Dicke von Laserdiodenbarren sowohl innerhalb eines Loses verschieden als auch zwischen mehreren Losen. Dasselbe gilt für die Zwischenelemente. Eine reproduzierbare Angleichung der Dicken von Laserdiodenbarren und Zwischenelementen bis auf weniger als 2 µm Differenz ist entweder fertigungstechnisch aufwändig oder von einem zeitraubenden Selektier- und Zuordnungsprozess begleitet.

Aufgabe der Erfindung ist es daher eine Wärmeübertragungsvorrichtung mit einem Halbleiterbauelement zu beschreiben, die die erwähnten Nachteile ausschließt.

Insbesondere ist es Aufgabe der Erfindung im kontinuierlichen Fertigungsprozess von Diodenlasem eine gleichbleibende und im wesentlichen konstante Dicke der Fügezonen zwischen den Laserdiodenbarren und den wärmeaufnehmenden Wärmeleitkörpern zu gewährleisten. Gleichzeitig ist es Aufgabe der Erfindung einen guten Wärmetransfer von einem Wärmeleitkörper zum anderen zu ermöglichen.

### Erfindungsbeschreibung

Die Aufgabe wird gelöst durch eine Wärmeübertragungsvorrichtung mit wenigstens einem Halbleiterbauelement, insbesondere einem Laser- oder Leuchtdiodenelement, mit den kennzeichnenden Merkmalen des Anspruches 1 und einem Verfahren zu seiner Montage nach Anspruch 15.

Das zwischen den Stützabschnitten angeordnete Distanzstück befindet sich erfindungsgemäß vom Halbleiterelement aus gesehen jenseits der Wärmetransferabschnitte. Es nimmt bei einer Verbindung der Wärmeleitkörper untereinander und / oder der Verbindung wenigstens einer Wärmeleitkörper mit dem Halbleiterbauelement einen Teil der Druckkraft auf, die vom einen auf den anderen Wärmeleitkörper bei der Montage ausgeübt wird, und gibt zwischen den Stützabschnitten die Distanz der Wärmeleitkörper voneinander vor. Bedingt durch seine bevorzugt große Entfernung vom Halbleiterbauelement, muss diese Distanz nicht genau der Dicke des Halbleiterbauelementes zuzüglich der ersten und zweiten Fügezone entsprechen, und der Winkelfehler, der durch eine entsprechende Abweichung hervorgerufen wird bleibt so klein, dass eine winkelfehlerbedingte Dickenvariation der ersten und zweiten Fügezone im vernachlässigbaren Bereich liegt.

Vorzugsweise ist die Dicke des Distanzstückes, beziehungsweise der Abstand der Stützpunkte, den Lagen einander gegenüberliegenden Stützflächen der Stützabschnitte hinsichtlich der Wärmeeintrittsflächen und der Dicke des Halbleiterbauelementes derart angepasst, dass eine Dickenvariation von keiner der ersten und zweiten Fügezonen mehr als +/- 50% betragen kann. Präzisiert auf Stütz- und Wärmeeintrittsflächen, die auf jedem der beiden Wärmeleitkörper zueinander koplanar auf einer gemeinsamen in einer Vorzugsrichtung orientierten Achse angeordnet sind, auf ein quaderförmiges Halbleiterbauelement und auf zwei gleich dicke ersten und zweiten Fügezonen der mittleren Dicke d, weieht der Abstand der Stützpunkte (die Dicke des Distanzstückes) in einem Abstand in Vorzugsrichtung vom Zentrum des Halbleiterbauelement, der dem p-fachen der Ausdehnung des Halbleiterbauelementes in Vorzugsrichtung entspricht, vorzugsweise um nicht mehr als +/- 2d (p-1) von der Dicke des Halbleiterbauelementes ab.

Sind die Stütz- und Wärmeeintrittsftächen zwar parallel zueinander, jedoch nicht koplanar, sondern zu einander versetzt, so erhöht beziehungsweise erniedrigt sich die vorgenannte zulässige Abweichung für jeden derartigen Wärmeleitkörper um eben diesen Versatz.

Der Umstand, dass die Dicke der dritten Fügezone zwischen den Wärmetransferabschnitten größer ist als die Dicken der ersten oder zweiten Fügezone macht die stützende Wirkung des Distanzstückes erst möglich, da andernfalls die stützende Wirkung im Bereich zwischen den Wärmetransferabschnitten liegt, was einerseits bekanntermaßen zu den eingangs genannten Problemen führt und andererseits unerwünschterweise dazu führt, dass die Dicke der dritten Fügezone die Dicke zumindest einer der ersten und der zweiten Fügezone bestimmt.

Für eine zuverlässige Kontaktierung eines Laserdiodenbarrens ist es aber gerade wünschenswert, dass die Dicke der ersten und zweiten Fügezonen die der von geringer Bedeutung - nämlich der dritten - bestimmen, was durch die abstützende Wirkung des Distanzstückes bei der Montage mit einer gegenüber der ersten und zweiten Fügezone erhöhten Dicke der dritten Fügezone bewirkt wird.

Unter einer Fügezone wird dabei die Schicht eines verfestigten Fügemittels verstanden. Fügezone und Fügespalt unterscheiden sich dadurch, dass die Fügezone nur Fügemittel enthält, der Fügespalt wenigstens eine Fügezone und optional weitere Bauelemente und Fügezonen, die gemeinsam den Fügespalt stoffschlüssig vollständig überbrücken.

So kann sich die dritte Fügezone kann sich vollständig über den Fügespalt erstrecken, wobei der Fügespalt vollständig und ausschließlich mit Fügemittel gefüllt ist. Andererseits kann sich die dritte Fügezone hinsichtlich ihrer Dicke auch nur über einen Teil des Abstandes zwischen den Wärmetransferabschnitten, der durch den Fügespalt vorgegeben ist, erstrecken. In diesem Fall können im Fügespalt zusätzlich zur dritten Fügezone eine vierte Fügezone sowie ein zwischen der dritten und vierten Fügezone positionierter Zwischenkörper angeordnet sein. Da Fügemittel in der Regel schlechtere Wärmeleiteigenschaften aufweisen als nicht als Fügemittel verwendbare Festkörper ist es vorteilhaft, bei Fügespalten, deren Dicken mehr als etwa der Hälfte der Dicke des Halbleiterbauelementes entsprechen, einen solchen Zwischenkörper aus Metall (beispielsweise Kupfer), Keramik (beispielsweise Aluminiumnitrid) oder Kristall (beispielsweise Diamant) zu verwenden.

Es ist unerheblich, in welcher Reihenfolge der Stoffschluss der Fügepartner erfolgt, ob und welche Fügemittel und/ oder Fügehilfsmittel zur Verbindung eingesetzt werden. Der Stoffschluss zwischen den Wärmetransferabschnitten kann a) nach Einrichtung des Stoffschlusses zwischen dem Halbleiterbauelement und dem ersten und dem zweiten Wärmeleitkörper erfolgen. Der Stoffschluss zwischen den Wärmetransferabschnitten kann darüber hinaus b) zumindest zeitweise gemeinsam mit der Einrichtung des Stoffschlusses zwischen dem Halbleiterbauelement und dem zweiten Wärmeleitkörper erfolgen, nachdem der Stoffschluss zwischen dem Halbleiterbauelement und dem ersten Wärmeleitkörper etabliert wurde - oder umgekehrt. Schließlich kann c) die Ausbildung des Stoffschlusses zwischen den Wärmetransferabschnitten zumindest zeitweise gemeinsam mit der Ausbildung der stoffschlüssigen Verbindungen des Halbleiterbauelementes mit beiden Wärmeleitkörpern erfolgen.

In allen Fällen sorgt das Distanzelement bei zumindest dem Fügeprozess, in dem beide Wärmeleitkörper miteinander stoffschlüssig werden - sei es vermittels des Halbleiterbauelementes über die erste und zweite Fügezone oder im Bereich der Wärmetransferabschnitte über die dritte Fügezone - durch seine stützende Wirkung für eine ausgeglichene Fügezonendicke derjenigen Fügezonen, an dessen Herstellung es erfindungsgemäß beteiligt ist.

Erfindungsgemäß ist es vorteilhaft, wenn die Dicke der dritten Fügezone größer ist als die Dicke derjenigen der ersten oder zweiten Fügezone, die zumindest zeitweise gemeinsam mit der dritten gebildet wird.

Sind die Dicken der ersten und der zweiten Fügezonen einander ähnlich und klein - beispielsweise im Bereich von 1 Mikrometer bis etwa 10 Mikrometern mit einem maximalen Dickenverhältnis von zwei - so ist es vorteilhaft, wenn die Dicke der dritten Fügezone größer ist als die Dicken der ersten und der zweiten Fügezone - womit sie größer ist als die größere Dicke von denjenigen der ersten und der zweiten Fügezone.

Im Interesse einer weiteren Entlastung der montagetechnischen Anforderungen weist die dritte Fügezone zumindest abschnittsweise eine größere Dicke auf als die Summe der Dicken der ersten und zweiten Fügezonen.

Die Erfindung bewirkt die Einrichtung einer effizienten Wärmeumleitung durch stoffschlüssiges Verbinden von Wärmeleitkörperteilen abseits des Halbleiterbauelementes, welches daselbst mit qualitätsgerechter Fügepräzision zur effizienten Wärmeabgabe zwischen die Wärmeleitkörper gelötet wird.

Die Verwendung eines Distanzstückes während der Montage bedeutet nicht unbedingt, dass das Distanzstück nach der Montage in seiner Position verbleiben muss. Sind die Wärmeleitkörper zumindest in den Stützabschnitten metallisch und steht ihr jeweiliger metallischer Bereich mit den entsprechenden Kontaktflächen des Halbleiterbauelementes in elektrischer Verbindung, so kann ein elektrisch leitfähiges, vorzugsweise metallisches, Distanzstück als Kurzschlussbrücke zwischen den metallischen Stützabschnitten verwendet werden, die das Halbleiterbauelement vor elektrostatischen Entladungen (ESD) schützt. Bei der Inbetriebnahme des montierten Halbleiterbauelementes, beispielsweise eines Diodenlasers, wird diese Kurzschlussbrücke entfernt und kann nach erfolgtem Betrieb wieder- das Halbleiterbauelement kurzschließend - zwischen die Stützabschnitte eingefügt werden.

Vorzugsweise weisen dazu die Wärmeleitkörper jeweils wenigstens einen metallischen Bereich auf oder bestehen überwiegend oder vollständig aus Metall oder einem elektrisch leitfähigen Kohlenstoff-Metall-Verbundwerkstoff - beispielsweise Diamant-Silber. Die elektrisch leitfähigen Bereiche erstrecken sich jeweils vom Stützabschnitt in den Wärmeaufnahmeabschnitt des Wärmeleitkörpers und stehen mit den entsprechenden Kontaktflächen des Halbleiterbauelements in elektrischer Verbindung. Sind einander zugewandte Wärmetransferflächen der Wärmetransferabschnitt, jeweils Bestandteil dieser elektrisch leitfähigen Bereiche, so muss die die Verbindung der beiden Wärmetransferabschnitte eine elektrische Isolierung aufweisen - entweder in Form eines elektrisch isolierenden Zwischenkörpers oder in Form einer Fügezone mit einem elektrisch isolierenden Fügemittel.

Ist andererseits nur eine der einander zugewandten Wärmetransferflächen der Wärmetransferabschnitte oder keine von ihnen Bestandteil dieser elektrisch leitfähigen Bereiche, so kann auch ein elektrisch leitfähiges Fügemittel - beispielsweise ein metallisches Lot - zur Verbindung der beiden Wärmetransferabschnitte zum Einsatz kommen, ohne dass ein elektrisch isolierender Zwischenkörper eingesetzt werden müsste. In diesem Fall können beide Wärmeleitkörper mit einer einzigen metallischen Lotschicht direkt miteinander verbunden werden. Dies ist unter anderem möglich mit Wärmeleitkörpern, die überwiegend aus hoch wärmeleitfähigen elektrisch isolierenden Materialien, beispielsweise Aluminiumnitrid, Berylliumoxid, Diamant usw., bestehen und elektrische Leiter tragen, die sich von einander gegenüberliegenden Stützflächen der Stützabschnitte zu einander gegenüberliegenden Wärmeeintrittsflächen der Wärmeaufnahmeabschnitte erstrecken. Weitere metallische Leiter können auf einander gegenüberliegenden Flächen der Wärmetransferabschnitte aufgebracht sein, ohne in elektrischer Verbindung mit dem Halbleiterbauelemente zu stehen, um die direkte Verbindung der Wärmeleitkörper mit Hilfe eines metallischen Lotes zu erleichtern. Nichtsdestoweniger kann selbstverständlich auch ein Aktivlot, das nichtmetallische Bereiche der Wärmetransferabschnitte benetzt, zur Verbindungsbildung eingesetzt werden.

Bei der Verwendung von metallischen Wärmeleitkörpern ist aus produktionstechnischen und finanziellen Gründen der Verzicht auf ein elektrisch isolierendes Zwischenelement zugunsten eines elektrisch isolieren Fügemittels vorteilhaft. Während aus thermischen Gründen die Dicke der elektrisch isolierenden Fügezone möglichst klein sein sollte, fordert die erfindungsgemäße Montagetechnik eine Dicke der dritten Fügezone von wenigstens der kleineren der Dicken der ersten und der zweiten Fügezone. Darüber hinaus ist aus elektrischen Gründen eine Dicke erforderlich, die groß genug ist, die elektrische Isolierung im Produktionsprozess zuverlässig zu gewährleisten. Im Falle kleiner und ähnlicher Dicken der ersten und zweiten Fügezone, ist es vorteilhaft, wenn die Dicke der dritten Fügezonen größer ist als die größerer der Dicken der ersten und zweiten Fügezone; vorzugsweise ist sie sogar größer als ihre Summe.

Soll das Distanzstück nach Abschluss der Montage in seiner Position verbleiben - beispielsweise, weil es im Zuge oder vor der Montage oder stoffschlüssig an wenigstens einem Wärmeleitkörper befestigt wurde, - so ist bei Verwendung von Wärmeleitkörpern, deren gegenüberliegende Stützflächen zu metallischen Bereichen gehören, die in elektrischer Verbindung mit dem Halbleiterbauelement stehen, ein elektrisch isolierendes Distanzstück zu verwenden.

In diesem Sinne wird darüber hinaus klar, dass das Distanzstück zu keinem Zeitpunkt notwendigerweise als separates Bauelement vorliegen muss. Während aus Gründen der Symmetrie zu dem Halbleiterbauelement und der damit verbundenen Vereinfachung der Erzielung der notwendigen Fügetoleranzen der körperlichen Individualität des Distanzstückes prinzipiell der Vorzug gegeben wird, ist in einer weniger bevorzugten Weiterbildung der Erfindung das Distanzstück integraler Bestandteil wenigstens eines der beiden Wärmeleitkörper und liegt in Form einer Erhebung vor, die in Richtung des Halbleiterbauelementes über den Wärmetransferabschnitt hinaus aus dem Stützabschnitt ragt. Vorteilhafterweise ließe sich damit immerhin die Anzahl der zur Montage verwendeten Bauelemente um eines von fünf auf vier oder von vier auf drei reduzieren.

Vorzugsweise erfolgt die elektrische Kontaktierung des Halbleiterbauelementes ohne Hinzunahme weiterer Körper oder Bauelemente in der Wärmeübertragungsvorrichtung vermittels der Wärmeleitkörper, wozu Wärmeeintrittsflächen auf metallischen Bereichen der Wärmeaufnahmeabschnitte liegen. Vorzugsweise ist sind beide Wärmeleitkörper metallisch. Die Verbindung der Wärmeleitkörper mit den Kontaktflächen erfolgt vorzugsweise mit einem metallischen Lot - beispielsweise Gold-Zinn, Indium usw..

Vorzugsweise sind die Wärmeleifkörper plattenfömig ausgebildet.

Zur Gewährleistung eines hohen thermischen Leitwertes der Wärmeleitplatten ist die Dicke der Platten in senkrechter Richtung zu wenigstens einer der Kontaktflächen vorzugsweise größer ist als wenigstens eine laterale Abmessung des Halbleiterbauelementes parallel zu einer oder beiden Kontaktflächen. Übertragen auf Einzellaserdioden bedeutet dies, dass Plattendicke größer ist als die senkrecht zur Lichtemissionsrichtung/ Resonatorlänge und parallel zur Ebene einer oder beider Kontaktflächen gerichtete Breite der Laserdiode; übertragen auf Laserdiodenbarren bedeutet dies, dass Plattendicke größer ist als die Resonatorlänge des Laserdiodenbarrens.

Zur Gewährleistung eines hohen thermischen Leitwertes der Fügezone ist die flächenmäßige Ausdehnung der Fügezone größer als die parallele flächenmäßige Ausdehnung des Laserdiodenelementes.

Nachfolgend wird die Erfindung anhand von Ausführungsbeispielen näher erläutert. Dazu zeigen
Fig. 1a eine Seitenansicht auf die Bauteile eines ersten Ausführungsbeispieles der erfindungsgemäßen Wärmeübertragungsvorrichtung
Fig. 1b eine Seitenansicht auf das erste Ausführungsbeispieles der erfindungsgemäßen Wärmeübertragungsvorrichtung,
Fig. 2a eine Seitenansicht auf die Bauteile eines zweiten Ausführungsbeispieles der erfindungsgemäßen Wärmeübertragungsvorrichtung,
Fig. 2b eine Seitenansicht auf das zweite Ausführungsbeispieles der erfindungsgemäßen Wärmeübertragungsvorrichtung.

Alle Ausführungsbeispiele repräsentieren Diodenlaserbauelemente mit einem Laserdiodenbarren. Nichtsdestoweniger können sie auch Strahlungsquellen mit einem oder mehreren nebeneinander angeordneten Einzel- oder Mehrfachemitterlaserdioden oder Einzel- oder Mehrfachemitterleuchtdioden oder Leuchtdiodenbarren repräsentieren. Darüber hinaus ist die Wärmeübertragungsvorrichtung auch zur Kühlung von Halbleiterschaltelementen, beispielsweise Hochleistungstransistoren, Hochleistungsthyristoren usw. geeignet.

### Ausführungsbeispiel 1

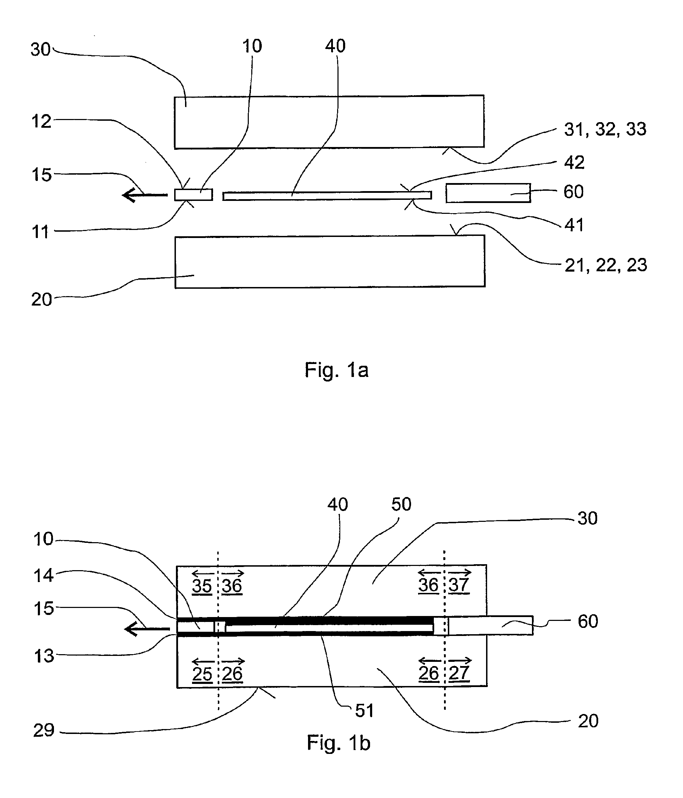

Die für die Herstellung einer ersten Variante des ersten Ausführungsbeispieles der erfindungsgemäßen Wärmeübertragungsvorrichtung verwendeten Bauelemente sind in Fig. 1a dargestellt: Der Laserdiodenbarren 10 weist eine erste, epitaxieseitige Kontaktfläche 11 zur elektrischen Kontaktierung auf sowie eine zweite, substratseitige Kontaktfläche 12, die der epitaxieseitigen Kontaktfläche gegenüberliegt. Der Laserdiodenbarren besitzt eine Resonatorlänge von 2mm. Die im Betrieb erfolgende Lichtemission ist durch den Pfeil 15 gekennzeichnet, der auf einer optischen Achse angeordnet ist. In der Lichtemission entgegengesetzter Richtung ist eine Aluminiumnitridkeramikplatte 40 von 100µm Dicke hinter dem 120µm dicken Laserdiodenbarren angeordnet. Sie besitzt einander gegenüberliegende epitaxie- und substratseitig orientierte, metallisierte Wärmeübergangsflächen 41 und 42.

Ein erster, epitaxieseitiger, plattenförmiger Wärmeleitkörper 20 besteht überwiegend aus einem Diamant-Silber-Verbundwerkstoff und weist eine der epitaxieseitigen Kontaktfläche 11 gegenüberliegenden Wärmeeintrittsfläche 21 auf sowie eine Wärmetransferfläche 22, die der epitaxieseitigen Wärmeübergangsfläche 41 der Aluminiumnitridkeramikplatte 40 gegenüberliegt. Seine Dicke beträgt 4mm.

Ein zweiter, substratseitiger, plattenförmiger Wärmeleitkörper 30 besteht ebenfalls überwiegend aus einem Diamant-Silber-Verbundwerkstoff und weist eine der substratseitigen Kontaktfläche 12 gegenüberliegenden Wärmeeintrittsfläche 31 auf sowie eine Wärmetransferfläche 32, die der substratseitigen Wärmeübergangsfläche 42 der Aluminiumnitridkeramikplatte 40 gegenüberliegt. Seine Dicke beträgt ebenfalls 4mm.

Die Aluminiumnitridkeramikplatte 40 besitzt eine Länge - das heißt eine Erstreckung in einer Vorzugsrichtung, die der Erstreckungsrichtung der Wärmeleitkörper 20/ 30 vom Wärmeaufnahmeabschnitt 25/35 zum Stützabschnitt 27/37 (in der Zeichnungsebene von links nach rechts) entspricht - von 10mm.

In Vorbereitung der Einrichtung eines Stoffschlusses dieser Komponenten 10, 20, 30, 40 zur Ausbildung der ersten Variante der ersten Ausführungsbeispieles wird der epitaxieseitige Wärmeleitkörper 20 im Bereich der epitaxieseitigen Wärmeeintrittsfläche 21 und im Bereich der epitaxieseitigen Wärmetransferfläche 22 mit 5 µm Gold-Zinn-Lot beschichtet. Analog wird der substratseitige Wärmeleitkörper 30 im Bereich der substratseitigen Wärmeeintrittsfläche 31 und im Bereich der substratseitigen Wärmetransferfläche 32 mit 5 µm Gold-Zinn-Lot beschichtet.

Ferner wird zwischen die Lotschicht auf substratseitigen Wärmetransferfläche 32 des epitaxieseitigen Wärmeleitkörpers 20 und der substratseitigen Wärmeübergangsfläche 42 der Aluminiumnitridkeramikplatte 40 eine Folie einer Gold-Zinn-Lot-Vorform von 25 µm Dicke eingebracht. Auf der von dem Laserdiodenbarren 10 abgewandten Seite der Aluminiumnitridkeramikplatte 40 ist ein Edelstahlfolie 60 mit einer Dicke von 125 µm als Distanzstück zwischen zwei einander gegenüberliegende Stützflächen 23 und 33 des epitaxieseitigen Wärmeleitkörpers 20 und des substratseitigen Wärmeleitkörpers 30 angeordnet.

Verschiedene, funktional unterschiedlich wirkende, Abschnitte der Wärmeleitkörper sind in Fig. 1b durch gestrichelte Trennlinien hervorgehoben.

Zur Einrichtung des Stoffschlusses der zu fügenden Komponenten 10, 20, 30, 40, wird in einem ersten Fügeprozess der Laserdiodenbarren 10 epitaxieseitig auf den epitaxieseitigen Wärmeaufnahmeabschnitt des epitaxieseitigen Wärmeleitkörpers 20 gelötet und die Aluminiumnitridkeramikplatte 40 auf den epitaxieseitigen Wärmetransferabschnitt 26 des epitaxieseitigen Wärmeleitkörpers 20.

Zur Vorbereitung des zweiten Fügeprozess, der den substratseitigen Wärmeleitkörper 30 mit dem Laserdiodenbarren 10 und der Aluminiumnitridkeramikplatte 40 verbinden soll, ist zu berücksichtigen, dass der Stapel aus Aluminiumnitridkeramikplatte 40 und Lot-Vorform zusammen mit den Lotbeschichtungen die gegenüber der Ebene der Flächen 31, 32 und 33 mit 135µm die größte Erhebung ab der Ebene der Flächen 21, 22 und 23 aufweist. Demgegenüber weist der Laserdiodenbarren zusammen mit den Lotschichten nur eine Höhe von 130µm auf während das Distanzstück 125µm zählt. Damit liegt der substratseitige Wärmeleitkörper nur im Bereich des Wärmetransferabschnittes auf. Während des zweiten Fügeprozesses schmilzt die Lot-Vorform auf und gibt unter einem über den substratseitigen auf den epitaxieseitigen Wärmeleitkörper aufgebrachten Druck nach. Dabei kommen der substratseitige Wärmeaufnahmeabschnitt 31 in Kontakt mit der substratseitigen Kontaktfläche 12 des Laserdiodenbarrens und der substratseitige Stützabschnitt in Kontakt mit dem Distanzstück, das auf dem epitaxieseitigen Stützabschnitt aufliegt.

Alle Komponenten haben am Ende des Montageprozesses Temperaturprofile durchlaufen die geeignet sind, sowohl eine hochwertige Lötverbindung 13 zwischen dem Laserdiodenbarren 10 und einem epitaxieseitigen Wärmeaufnahmeabschnitt 25 des epitaxieseitigen Wärmeleitkörpers 20, als auch eine hochwertige Lötverbindung 14 zwischen dem Laserdiodenbarren 10 und einem substratseitigen Wärmeaufnahmeabschnitt 35 des substratseitigen Wärmeleitkörpers 30, als auch eine hochwertige Lotverbindung 51 zwischen der Aluminiumnitridkeramikplatte 40 und einem sich entgegen Lichtemissionsrichtung 15 über den Laserdiodenbarren 10 hinaus erstreckenden epitaxieseitigen Wärmetransferabschnitt 26 des epitaxieseitigen Wärmeleitkörpers 20, als auch eine hochwertige Lotverbindung 50 zwischen der Aluminiumnitridkeramikplatte 40 und einem sich entgegen Lichtemissionsrichtung 15 über den Laserdiodenbarren 10 hinaus erstreckenden substratseitigen Wärmetransferabschnitt 36 des substratseitigen Wärmeleitkörpers 30 einzurichten.

Dabei weist die Lotverbindung 50 eine größere Dicke auf als die übrigen drei Lotverbindungen 13, 14 und 51. Sie überbrückt die sichere Toleranz von der in zu niedriger Dicke gefertigten Aluminiumnitridkeramikplatte 40 im Abstand zum substratseitigen Wärmeleitkörper.

Das Distanzstück 60 beugt einer Verkippung der Bauelemente zueinander in die Lotschicht 50 vor und sorgt dafür, dass die Dicken der Fügezonen 13 und 14 ebenso im wesentlichen konstant sind wie die Dicken der Fügezonen 50 und 51.

Man kann in einer vereinfachten Beschreibung des Fügeprozesses annehmen, dass sich die Lotschichtdicken aller Lotschichten im Fügeprozess mit Ausnahme der der Lot-Vorform nicht verändern, während sich die Dicke der Lotschicht der Lot-Vorform den Abständen anpasst, die durch den Laserdiodenbarren 10 zusammen mit seinen Lotschichten (insgesamt 130µm) und das Distanzstück 60 (125 µm) vorgegeben werden. Damit verringert sich die Dicke des Lotes der Lot-Vorform um 20% bis 40% auf 15 bis 20 µm. Mit dem Fügeprozess gehen aus den Lotschichten Fügezonen hervor, deren Dicke mit Ausnahme der der ersten Lotverbindung 50 denen der Lotschichten entspricht. Die Dicke der Fügezone 50 zwischen der Aluminiumnitridkeramikplatte 40 und dem substratseitigen Wärmetransferabschnitt 36 des substratseitigen Wärmeleitkörpers 30 variiert dabei keilförmig von 25 µm auf der dem Laserdiodenbarren 10 zugewandten Seite bis auf 20 µm auf der dem Stützelement zugewandten Seite. Insgesamt verläuft der Fügespalt zwischen dem epitaxieseitigen Wärmetransferabschnitt 26 und dem substratseitigen Wärmetransferabschnitt 36 ebenso keilförmig, weil seine Dicke, die dem Abstand der beiden Wärmetransferabschnitte 26 und 36 voneinander entspricht, durch die Abstandshalter zwischen den Wärmeeintragsabschnitten 25 und 35 (Laserdiodenbarren 10 mit Lotfugen 13 und 14) und zwischen den Stützabschnitten 27 und 37 (Distanzstück 60) vorgegeben ist. Auf der dem Laserdiodenbarren 10 zugewandten Ende beträgt seine Dicke 130 µm, auf der dem Distanzstück 60 zugewandten Ende 125 µm.

Zum Betrieb des Laserdiodenbarrens in der Wärmeübertragungsvorrichtung wird eine Wärmesenke an einer Wärmeabgabefläche befestigt, die auf einer vom Laserdiodenbarren 10 und der Aluminiumnitridkeramikplatte 40 abgewandten Seite 29 des epitaxieseitigen Wärmeleitkörpers 20 angeordnet ist; ein erster elektrischer Anschluss wird am epitaxieseitigen Wärmeleitkörper 20 befestigt und ein zweiter elektrischer Anschluss am substratseitigen Wärmeleitkörper 30. Das den epitaxieseitigen und den substratseitige Kontakt des Laserdiodenbarrens 10 über die Wärmeleitkörper 20 und 30 kurzschließende Distanzstück wird aus seiner Position entfernt.

Beim Betrieb des Laserdiodenbarrens wird die in der aktiven Zone erzeugte Wärme zu einem ersten Teil über die epitaxieseitige Kontaktfläche 11, die epitaxieseitige Lotfuge 13 und die epitaxieseitige Wärmeeintrittsfläche 21 vom epitaxieseitigen Wärmeaufnahmeabschnitt 25 des epitaxieseitigen Wärmeleitkörpers 20 aufgenommen und zumindest teilweise in den epitaxieseitigen Wärmetransferabschnitt 26 hinein gespreizt. Zu einem zweiten Teil wird die Wärme über die substratseitige Kontaktfläche 12, die substratseitige Lotfuge 14 und die substratseitige Wärmeeintrittsfläche 31 vom substratseitigen Wärmeaufnahmeabschnitt 35 des substratseitigen Wärmeleitkörpers 30 aufgenommen und zumindest nahezu vollständig in den substratseitigen Wärmetransferabschnitt 36 hinein geleitet. Aus dem substratseitigen Wärmetransferabschnitt 36 wird der zweite Wärmeteil über die substratseitige Wärmetransferfläche 32, die Lotverbindung 50, die substratseitige Wärmeübergangsfläche 42, die Aluminiumnitridkeramikplatte 40, die epitaxieseitige Wärmeübergangsfläche 41, die Lotverbindung 51 und die epitaxieseitige Wärmetransferfläche 22 in den epitaxieseitigen Wärmetransferabschnitt 26 des epitaxieseitigen Wärmeleitkörpers 20 überführt und dort mit dem ersten Wärmeteil vereinigt. Die Wärme wird dann über die Wärmeabgabefläche 29 zur Wärmeabfuhr an einen Wärmesenkenkörper abgegeben.

Die Aluminiumnitridkeramikplatte 40 sorgt für eine elektrische Isolierung zwischen den Wärmeleitkörpern 20 und 30, zwischen denen für den Betrieb des Laserdiodenbarrens eine entsprechende Potentialdifferenz bestehen muss. Da die Dicke der Aluminiumnitridkeramikplatte 40 nur geringfügig kleiner ist als die des Laserdiodenbarrens, sind auch die Dicken der Lotfugen 50 und 51 relativ klein, nämlich 25µm und 5µm. Trotz einer moderaten Wärmeleitfähigkeit des Gold-Zinn-Lotes bleibt daher unter Berücksichtigung der hohen thermischen Leitfähigkeit der Aluminiumnitridkeramikplatte 40 der thermische Widerstand des Wärmeübergangs vom substratseitigen Wärmetransferabschnitt 36 zum epitaxieseitigen Wärmetransferabschnitt 26 gering.

Damit kann tatsächlich der substratseitige Wärmeleitkörper zur doppelseitigen Kühlung des Laserdiodenbarrens effizient genutzt werden.

### Ausführungsbeispiel 2

Im Gegensatz zum ersten Ausführungsbeispiel kommt das zweite Ausführungsbeispiele ohne die Verwendung einer zwischen die Wärmeleitkörper gebrachten Platte 40 zur elektrischen Isolierung aus. Statt dessen wird eine Fügezone mit einem elektrisch isolierenden Fügemittel zur elektrisch isolierenden Verbindung der Wärmeleitkörper verwendet. Dazu ist wenigstens einer der Wärmeleitkörper 20, 30 - im vorliegenden Ausführungsbeispiel beide Wärmeleitkörper 20 und 20 - mit einer Erhebung im Bereich des Wärmetransferabschnittes 26, 36 versehen, der sich in der stoffschlüssigen Wärmeübertragungsvorrichtung bis in die rückwärtige Flucht des Laserdiodenbarrens 10, das heißt bis zwischen die beiden Kontaktflächenebenen, erstreckt. Damit liegen die Wärmeeintrittsflächen 21, 31 der Wärmeaufnahmeabschnitte 25, 35 jeweils zusammen mit den Stützflächen 23, 33 der Stützabschnitte 27, 37 in einer gemeinsamen Ebene, die ihrerseits bezüglich der Ebenen der der Wärmetransferflächen 22, 32 in den Wärmetransferabschnitten 26, 36 parallel versetzt liegt.

Das zweite Ausführungsbeispiel kommt im Gegensatz zum ersten Ausführungsbeispiel mit einem Minimum an Komponenten aus.

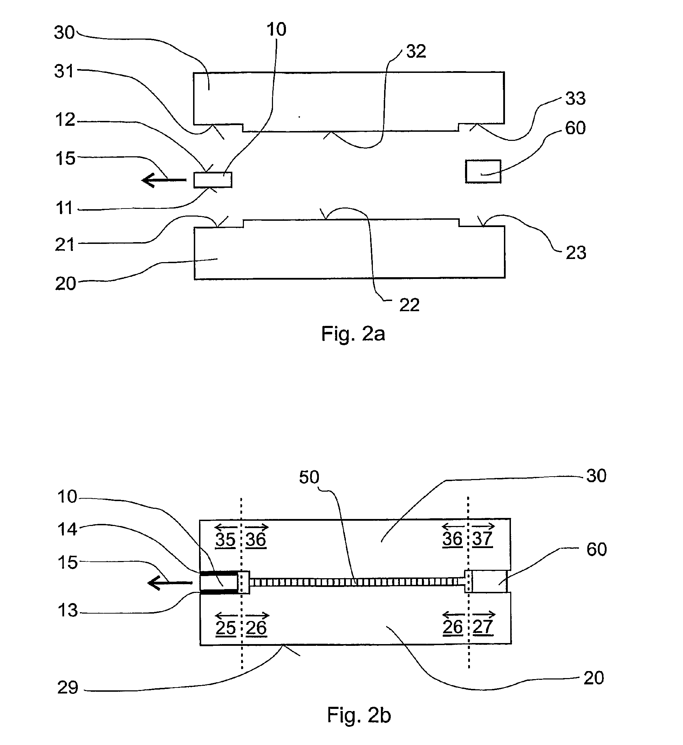

Die Komponenten des zweiten Ausführungsbeispieles sind in Figur 2a dargestellt. Die Wärmeleitkörper 20 und 30 bestehen überwiegend aus Kupfer. Die Wärmeeintrittsflächen 21 und 31 sind am Boden von Ausnehmungen in den Wärmeaufnahmeabschnitten 25 und 35 gegenüber den Wärmetransferflächen 22 und 32 in den Wärmetransferabschnitten 26 und 36 um 50µm parallel in vom Laserdiodenbarren fortweisender Richtung versetzt. Das Paar von Ausnehmungen bietet, wie in Fig. 2b veranschaulicht, Raum zur Aufnahme des Laserdiodenbarrens 10, welcher mit Indiumlot 13 und 14 stoffschlüssig in einem einzigen Lötprozess beidseitig an die Wärmeaufnahmeabschnitte 25 und 35 der Wärmeleitkörper 20 und 30 gelötet wird.

Ebenso sind die Stützflächen 23 und 33 am Boden von Ausnehmungen in den Stützabschnitten 27 und 37 gegenüber den Wärmetransferflächen 22 und 32 in den Wärmetransferabschnitten 26 und 36 um 50µm parallel in vom Laserdiodenbarren fortweisender Richtung versetzt. Dieses Paar von Ausnehmungen bietet, wie in Fig. 2b veranschaulicht, Raum zur Aufnahme einer Polyimidfolie 60 von 125µm Dicke, welche mittels eines Klebstoffes vor Durchführung des vorgenannten Lötprozesses auf der Stützfläche 23, 33 eines der Wärmeleitkörper 20, 30 befestigt wird.

Zusammen mit dem erwähnten Lötprozess härtet ein zuvor zwischen die beiden Wärmetransferabschnitte 26 und 36 der Wärmeleitkörper 20 und 30 gebrachte, elektrisch isolierende Klebstoffschicht 50 stoffschließend aus. Bei Initiierung des Lötprozesses sorgt die Polyimidfolie als Distanzstück 60 bei der Ausübung einer Druckkraft vom substratseitigen Wärmeleitkörper 20 auf den epitaxieseitigen Wärmeleitkörper 30 dafür, dass sich eine Dicke der elektrisch isolierenden Klebstoffschicht 50 im Bereich von 25 bis 30 µm ausbildet, die die elektrische Isolierung der metallischen Wärmeleitkörper voneinander in zuverlässiger Weise gewährleistet. Gleichzeitig wird eine Indiumlotschicht von ausreichender Dickenhomogenität garantiert.

Nach Beendigung der Montage verbleibt die Polyimidfolie 60 in der Wärmeübertragungsvorrichtung.

### Bezugszeichenliste

- 10: Laserdiodenelement
- 11: epitaxieseitige Kontaktfläche
- 12: substratseitige Kontaktfläche
- 13: epitaxieseitige Lotfuge
- 14: substratseitige Lotfuge
- 15: Strahlungsemissionsrichtungspfeil
- 20: epitaxieseitiger Wärmeleitkörper
- 21: epitaxieseitige Wärmeeintrittsfläche
- 22: epitaxieseitige Wärmetransferfläche
- 23: epitaxieseitige Stützfläche
- 25: epitaxieseitiger Wärmeaufnahmeabschnitt
- 26: epitaxieseitiger Wärmetransferabschnitt
- 27: epitaxieseitiger Stützabschnitt
- 29: Wärmeabgabefläche
- 30: substratseitiger Wärmeleitkörper
- 31: substratseitige Wärmeeintrittsfläche
- 32: substratseitige Wärmetransferfläche
- 33: substratseitige Stützfläche
- 35: substratseitiger Wärmeaufnahmeabschnitt
- 36: substratseitiger Wärmetransferabschnitt
- 37: substratseitiger Stützabschnitt
- 40: elektrisch isolierende Platte
- 41: epitaxieseitige Übergangsfläche
- 42: substratseitige Übergangsfläche
- 50: erste Fügezone zwischen Wärmetransferabschnitten
- 51: zweite Fügezone zwischen Wärmetransferabschnitten
- 60: Distanzstück

## Patentansprüche

1. Wärmeübertragungsvorrichtung
mit
- wenigstens einem Halbleiterbauelement (10), insbesondere einem Laser- oder Leuchtdiodenelement,
- einem ersten Wärmeleitkörper (20),
- wenigstens einem zweiten Wärmeleitkörper (30)
wobei
das Halbleiterbauelement (10)
- auf einer ersten Seite wenigstens eine erste, zumindest abschnittsweise im wesentlichen ebene, Kontaktfläche (11) und
- auf wenigstens einer, der ersten Seite abgewandten, zweiten Seite wenigstens eine zweite, zumindest abschnittsweise im wesentlichen ebene, Kontaktfläche (12) aufweist, und
- zumindest zur abschnittsweise zwischen dem ersten und dem zweiten Wärmeleitkörper (20 und 30) angeordnet ist,
der erste Wärmeieitkörper (20)
- wenigstens einen ersten Wärmeaufnahmeabschnitt (25) mit wenigstens einer ersten Wärmeeintrittsfläche (21) aufweist, die der ersten Kontaktfläche (11) in einer dem Halbleiterbauelement (10) abgewandten Richtung zumindest abschnittsweise gegenüberliegt, und durch wenigstens einen sich in der senkrecht zur ersten Kontaktfläche (11) orientierten Flucht des Halblelterbauelementes (10) von der ersten Kontaktfläche (11) zur ersten Wärmeeintrittsfläche (21) erstreckenden Stoffschluss, der wenigstens eine erste Fügezone (13) aufweist, mit dem Halbleiterbauelement (10) verbunden ist,
sowie
- wenigstens einen ersten Wärmetransferabschnit (26), der sich in wenigstens einer ersten Wärmetransferrichtung zumindest abschnittsweise parallel zur ersten Kontaktfläche (11) über das Halbleiterbauelement (10) hinaus erstreckt,
der zweite Wärmeleitkörper (30)
- wenigstens einen zweiten Wärmeaufnahmeabschnitt (35) mit wenigstens einer zweiten Wärmeeintrittsfläche (31) aufweist, die der zweiten Kontaktfläche (12) in einer dem Halbleiterbauelement (10) abgewandten Richtung zumindest abschnittsweise gegenüberliegt, und durch wenigstens einen sich in der senkrecht zur zweiten Kontaktfläche (12) orientierten Flucht des Halbleiterbauelementes (10) von der zweiten Kontaktfläche (12) zur zweiten Wärmeeintrittsfläche (31) erstreckenden Stoffschluss, der wenigstens eine zweite Fügezone (14) aufweist, mit dem Halbleiterbauelement (10) werbunden ist,
sowie
- wenigstens einen zweiten Wärmetransferabschnitt (36), der sich in wenigstens einer, der ersten Wärmetransferrichtung parallelen, zweiten Wärmetransferrichtung zumindest abschnittsweise parallel zur zweiten Kontaktfläche (12) über das Halbleiterbauelement (10) hinaus erstreckt und dem ersten Wärmetransferabschnitt (26) des ersten Wärmeleitkörpers (20) zumindest bereichsweise gegenüberliegt, wobei
- die Wärmetransferabschnitte (26 und 36) des ersten und der zweiten Wärmeleitkörpers (20 und 30) über einen zumindest abschnittsweise zwischen einander gegenüberliegenden Bereichen der Wärmetransferabschnitte angeordneten Fügespalt, der wenigstens eine dritte Fügezone (50) aufweist, miteinander stoffschlüssig verbunden sind
**dadurch gekennzeichnet, dass**
der erste Wärmeleitkörper (20)
- wenigstens einen, sich an den ersten Wärmetransferabschnitt (26) anschließenden, ersten Stützabschnitt (27) aufweist,
der zweite Wärmeleitkörper (30)
- wenigstens einen, sich an den zweiten Wärmetransferabschnitt (36) anschließenden, Stützabschnitt (37) aufweist, der dem ersten Stützabschnitt (27) zumindest bereichsweise gegenüberliegt,
- zwischen einander gegenüberliegenden Bereichen der beiden Stützabschnitte (27 und 37) wenigstens ein Distanzstück (60) angeordnet ist,
- und die dritte Fügezone (50) zumindest abschnittsweise eine größere Dicke aufweist als die erste oder die zweite Fügezone (13 und 14).

2. Wärmeübertragungsvorrichtung nach Anspruch 1,
**dadurch gekennzeichnet, dass**
das Distanzstück (60) von körperlicher Individualität und damit als von den Wärmeleitkörpern separates Bauelement identifizierbar ist, oder **dadurch gekennzeichnet, dass**
das Distanzstück (60) integrierter oder integraler Bestandteil wenigstens eines der Wärmeleitkörper (20, 30) ist.

3. Wärmeübertragungsvorrichtung nach einem der vorhergehenden Ansprüche
**dadurch gekennzeichnet, dass**
das Distanzstück (60) zumindest teilweise zwischen den Ebenen angeordnet ist, in denen die erste und zweite Kontaktflächen (11 und 12) des Halbleiterbauelementes (10) liegegen, und/oder durch gekennzeichnet, dass
das Distanzstück (60) elektrisch isolierend ist.

4. Wärmeübertragungsvorrichtung nach einem der vorhergehenden Ansprüche
**dadurch gekennzeichnet, dass**
die Dicke des Distanzstückes (60) in einer zu wenigstens einer der Kontaktflächen (11, 12) senkrechten Richtung weniger als 50% von dem gegenseitigen Abstand der ersten und zweiten Kontaktfläche (11 und 12) abweicht, und/oder, **dadurch gekennzeichnet, dass**
die Dicke des Distanzstückes (60) in einer zu wenigstens einer der Kontaktflächen (11, 1 2) senkrechten Richtung größer ist als der gegenseitige Abstand der ersten und zweiten Kontaktfläche (11 und 12).

5. Wärmeübertragungsvorrichtung nach einem der vorhergehenden Ansprüche
**dadurch gekennzeichnet, dass**
das Halbleiterbauelement (10) ein Laserdiodenbarren ist, der wenigstens eine optische Achse der Strahlungsemission aufweist, und
die Ausdehnung wenigstens einer der Wärmeieitkörper (20, 30) auf zumindest einer Geraden, die senkrecht zu wenigstens einer der Kontaktflächen (11, 12) des Laserdiodenbarrens in wenigstens einer Ebene liegt, die sich senkrecht zu wenigstens einer der Kontaktflächen (11, 12) des Laserdiodenbarrens (10) und parallel zu der optischen Achse der Strahlungsemission durch den besagten Wärmeleitkörper (20, 30) und den Laserdiodenbarren (10) erstreckt, größer ist als wenigstens eine in der besagten Ebene liegende Erstreckung des Laserdiodenbarrens (10), die parallel zu wenigstens einer der Kontaktflächen (11,12) ausgerichtet ist.

6. Wärmeübertragungsvorrichtung nach Anspruch 5,
**dadurch gekennzeichnet, dass**
wenigstens eine Erstreckung der Fügezone (50) in der besagten Ebene wenigstens doppelt so groß ist wie die wenigstens eine in der besagten Ebene liegende Erstreckung des Laserdiodenbarrens (10), die parallel zu wenigstens einer der Kontaktflächen (11, 12) ausgerichtet ist.

7. Wärmeübertragungsvorrichtung nach einem der vorhergehenden Ansprüche,
**dadurch gekennzeichnet, dass**
dass die Stützabschnitte (27, 37) Stützflächen (23, 33) zur Auflage des Distanzstückes (60) und zur Auflage auf das Distanzstück (60) vorsehen, und/oder **dadurch gekennzeichnet, dass**
die Stüfzfläche (23, 33) wenigstens eines der Wärmeleitkörper (20, 30) mit der Wärmeeintriftsfläche (21, 31) desselben Wärmeleitkörpers (20, 30) bis auf einen Parallelversatz, der durch Fügezone (13, 14) bedingt ist, in einer gemeinsamen Ebene liegt.

8. Wärmeübertragungsvorrichtung nach einem der Ansprüche 1 bis 7,
**dadurch gekennzeichnet, dass**
der erste und der zweite Wärmeleitkörper (20 und 30) jeweils wenigstens eine zumindest abschnittsweise im Wärmeeintrittsabschnitt (25, 35) angeordnete oberflächliche Ausnehmung aufweist, deren Bodenfläche zumindest abschnittsweise die Wärmeeintrittsfläche (21, 31) bildet und welche das Halbleiterbauelement (10) zumindest abschnittsweise aufnimmt, sowie
jeweils wenigstens eine zumindest abschnittsweise im Stützabschnitt (27, 37) angeordnete oberflächliche Ausnehmung aufweist, deren Bodenfläche zumindest abschnittsweise die Stützfläche (23, 33) bildet, wobei der erste und der zweite Wärmetransferabschnitt (26 und 36) zumindest teilweise zwischen den Ebenen angeordnet ist, in denen die erste und zweite Kontaktfläche (11 und 12) des Halbleiterbauelementes (10) liegen, und/oder **dadurch gekennzeichnet, dass**
der erste Wärmetransferabschnitt (26) wenigstens einen ersten metallischen Bereich aufweist, der in elektrischer Verbindung mit der ersten Kontaktfläche (11) des Halbleiterbauelementes (10) steht,
der zweite Wärmetransferabschnitt (26) wenigstens einen zweiten metallischen Bereich aufweist, der in elektrischer Verbindung mit der zweiten Kontaktfläche (11) des Halbleiterbauelementes (10) steht,
und die dritte Fügezone (50) zumindest abschnittsweise ein elektrisch isolierendes Fügemittel aufweist, das in wenigstens einem Teilbereich des Fügespalts den dortigen Abstand zwischen dem ersten und zweiten metallischen Bereich wenigstens zur Hälfte stoffschlüssig überbrückt.

9. Wärmeübertragungsvorrichtung nach einem der vorhergehenden Ansprüche,
**dadurch gekennzeichnet, dass**
der erste und der zweite Wärmeleitkörper (20 und 30) überwiegend aus Kupfer und/ oder einem Kohlenstoff-Metall-Verbundwerkstoff bestehen.

10. Verfahren zur Montage eines Halbleiterbauelementes (10), insbesondere eines Laser- oder Leuchtdiodenelementes,
**gekennzeichnet durch** folgende Verfahrenschritte:
a)
zumindest abschnittsweises Einbringen des Halbleiterbauelementes (10),
das
- auf einer ersten Seite wenigstens eine erste, zumindest abschnittsweise im wesentlichen ebene, Kontaktfläche (11) und
- auf wenigstens einer, der ersten Seite abgewandten, zweiten Seite wenigstens zweite, zumindest abschnittsweise im wesentlichen ebene, Kontaktfläche (12) aufweist,
zwischen einen ersten und einen zweiten Wärmeleitkörper (20 und 30),
in der Weise, dass
- die erste Kontaktfläche (11) zumindest abschnittsweise einer ersten Wärmeeintrittsfläche (21) eines ersten Wärmeaufnahmeabschnittes (25) des ersten Wärmeleitkörpers (20) in einer dem Halbleiterbauelement (10) abgewandten Richtung gegenüberliegt, und
- die zweite Kontaktfläche (12) zumindest abschnittsweise einer zweiten Wärmeeintrittsfläche (31) eines zweiten Wärrneaufnahmeabschnittes (35) des zweiten Wärmeleitkörpers (30) in einer dem Halbleiterbauelement (10) abgewandten Richtung gegenüberliegt,
b)
stoffschlüssiges Verbinden des ersten Wärmeaufnahmeabschnittes (25) mit dem Halbleiterbauelement (10) unter Ausbildung einer ersten Fügezone (13) innerhalb eines Stoffschlusses, der sich in der senkrecht zur ersten Kontaktfläche orientierten Flucht des Halbleiterbauelementes (10) von der ersten Kontaktfläche (11) zur ersten Wärmeeintrittsfläche (21) erstreckt,
c)
stoffschlüssiges Verbinden des zweiten Wärmeaufnahmeabschnittes (35) mit dem Halbleiterbauelement (10) unter Ausbildung einer zweiten Fügezone (14) innerhalb eines Stoffschlusses, der sich In der senkrecht zur zweiten Kontaktfläche (12) orientierten Flucht des Halbleiterbauelementes von der zweiten Kontaktfläche (12) zur zweiten Wärmeeintrittsfläche (31) erstreckt,
d)
stoffschlüssiges Verbinden einander gegenüberliegender Bereiche eines ersten Wärmetransferabschnittes (26) des ersten Wärmeleitkörpers (20), der sich in wenigstens einer ersten Wärmetransferrichtung zumindest abschnittsweise parallel zur ersten Kontaktfläche (11) über das Halbleiterbauelement (10) hinaus erstreckt
und
eines zweiten Wärmetransferabschnittes (36) des zweiten Wärmeleitkörpers (30) der sich in wenigstens einer zweiten Wärmetransferrichtung zumindest abschnittsweise parallel zur zweiten Kontaktfläche (12) über das Halbleiterbauelement (10) hinaus erstreckt,
unter Ausbildung einer dritten Fügezone (50) die zumindest abschnittsweise eine größere Dicke aufweist als die erste oder die zweite Fügezone.
und
e)
Ausüben wenigstens einer Druckkraft während wenigstens einem der Verfahrensschritte b), c) und d) von einem Stützabschnitt (27, 37) auf einen anderen Stützabschnitt (37, 27) der Wärmeleitkörper (20 und 30) über ein Distanzstück (60),
das zumindest abschnittsweise in einer Stützposition zwischen einander gegenüberliegenden Bereichen eines ersten Stützabschnittes (27) des ersten Wärmeleitkörpers (20), der sich an den ersten Wärmetransferabschnitt (26) anschließt,
und
eines zweiten Stützabschnittes (37) des zweiten Wärmeleitkörpers (30), der sich an den zweiten Wärmetransferabschnitt (36) anschließt,
angeordnet ist.

11. Verfahren zur Montage eines Halbleiterbauelementes nach Anspruch 10,
**dadurch gekennzeichnet, dass**
die Verfahrensschritte b) und d) oder die Verfahrensschritte c) und d) zumindest zeitweise in einem gemeinsamen Verbindungsprozeß erfolgen, wobei die Dicke der dritten Fügezone (50) umindest abschnittsweise größer ist als die Dicke derjenigen der ersten oder zweiten Fügezone (13 oder 14) die zumindest zeitweise gemeinsam mit der dritten Fügezone (50) gebildet wird, und/oder **dadurch gekennzeichnet, dass**
die Verfahrensschritte b), c) und d) zumindest zeitweise in einem gemeinsamen Verbindungsprozeß erfolgen, wobei die Dicke der dritten Fügezone (50) zumindest abschnittsweise größer ist als die Summe der Dicken der ersten und der zweiten Fügezone (13 und 14).

12. Verfahren zur Montage eines Halbleiterbauelementes nach Anspruch 10 oder 11,
**dadurch gekennzeichnet, dass**
in Vorbereitung des Verfahrensschrittes d) ein elektrisch isolierendes Fügemittel zwischen die Wärmetransferabschnitte (26 und 36) der beiden Wärmeleitkörper (20 und 30) eingebracht wird.

13. Verfahren zur Montage eines Halbleiterbauelementes nach einem der Ansprüche 10 bis 12, **dadurch gekennzeichnet, dass**
dass in Vorbereitung des Verfahrensschrittes e) das Distanzstück (60) zwischen die Stützabschnitte (27, 37) der Wärmeleitkörper (20, 30) eingebracht wird und während des Verfahrensschrittes e) in der Stützposition auf einer druckaufnehmenden Stützfläche (23, 33) des Stützabschnittes (27, 37) aufliegt und eine druckgebende Stützfläche (33, 23) des anderen Stützabschnittes (37, 27) auf dem Distanzstück 60 aufliegt, und/oder **dadurch gekennzeichnet, dass**
das Distanzstück (60) elektrisch leitfähig ist und in seiner Stützposition einen ersten metallischen Bereich, der mit der ersten Kontaktfläche (11) des Halbleiterbaueiementes (10) in elektrischer Verbindung steht, mit einem zweiten metallischen Bereich, der mit der zweiten Kontaktfläche des Halbleiterbauelementes in elektrischer Verbindung steht, elektrisch verbindet, wobei bervorzugt der erste Wärmeleitkörper (20) den ersten metallische Bereich aufweist und der zweite Wärmeleitkörper (30) den zweiten metallischen Bereich.

14. Verfahren zur Montage eines Halbleiterbauelementes nach Anspruch 13,
**dadurch gekennzeichnet, dass**
das Distanzstück (60) zum Betrieb des Halbleiterbauelementes (10) aus seiner Stützposition entfernt wird.

15. Verfahren zur Montage eines Halbleiterbauelementes nach einem der Ansprüche 10 bis 14, **dadurch gekennzeichnet, dass**
zum Betrieb des Halbleiterbauelementes (10) wenigstens einer der Wärmeleitkörper (20 oder 30) auf einer dem Halbleiterbauelement (10) abgewandten Seite an wenigstens eine Wärmesenke angeschlossen wird.

## Claims

1. Heat transfer device
comprising
- at least one semiconductor component (10), in particular a laser or light-emitting diode element,
- a first heat conducting body (20),
- at least one second heat conducting body (30)
wherein
the semiconductor component (10)
- has on a first side, at least a first contact surface (11), sections at least of which are substantially flat and
- has on at least a second side facing away from the first side, at least a second contact surface (12), sections at least of which are substantially flat and
- is at least sectionally arranged between the first and the second heat conducting body (20 and 30),
the first heat conducting body (20)
- has at least a first heat absorbing section (25) with at least a first heat entry surface (21) sections at least of which lie opposite the first contact surface (11) in a direction facing away from the semiconductor component (10), and is connected to the semiconductor component (10) by at least one adhesion bond in the line, oriented perpendicular to the first contact surface (11), of the semiconductor component (10) extending from the first contact surface (11) to the first heat entry surface (21), which has at least a first joining zone (13)
as well as
- at least a first heat transfer section (26) sections at least of which extend beyond the semiconductor component (10) in at least a first heat transfer direction parallel to the first contact surface (11),
the second heat conducting body (30)
- has at least a second heat absorbing section (35) with at least a second heat entry surface (31) sections at least of which lie opposite the second contact surface (12) in a direction facing away from the semiconductor component (10), and is connected to the semiconductor component (10) by at least one adhesion bond in the line, oriented perpendicular to the second contact surface (12), of the semiconductor component (10) extending from the second contact surface (12) to the second heat entry surface (31), which has at least a second joining zone (14) as well as
- at least a second heat transfer section (36) sections at least of which extend beyond the semiconductor component (10) in at least a second heat transfer direction parallel to the first heat transfer direction parallel to the second contact surface (12) and sections at least of which lie opposite the first heat transfer section (26) of the first heat conducting body (20),
wherein
- the heat transfer sections (26 and 36) of the first and the second heat conducting bodies (20 and 30) are connected to each other by adhesion via a joining gap, sections at least of which are arranged between opposing regions of the heat transfer sections, which has at least a third joining zone (50)
**characterized in that**
the first heat conducting body (20)
- has at least a first support section (27) adjoining the first heat transfer section (26),
the second heat conducting body (30)
- has at least one support section (37), adjoining the second heat transfer section (36), sections at least of which lie opposite the first support section (27),
- at least one spacer (60) is arranged between opposing regions of the two support sections (27 and 37),
- and sections at least of the third joining zone (50) have a greater thickness than the first or the second joining zone (13 and 14).

2. Heat transfer device according to claim 1
**characterized in that**
the spacer (60) can be identified as a distinct physical entity and thus as a component separate from the heat conducting bodies, or **characterized in that** the spacer (60) is an integrated or integral constituent of at least one of the heat conducting bodies (20, 30).

3. Heat transfer device according to one of the previous claims
**characterized in that**
the spacer (60) is arranged at least partly between the planes in which the first and second contact surfaces (11 and 12) of the semiconductor component (10) lie, and/or **characterized in that**
the spacer (60) is electrically insulating.

4. Heat transfer device according to one of the previous claims
**characterized in that**
the thickness of the spacer (60) in a direction perpendicular to at least one of the contact surfaces (11, 12) differs by less than 50% from the opposite distance between the first and second contact surfaces (11 and 12), and/or **characterized in that**
the thickness of the spacer (60) in a direction perpendicular to at least one of the contact surfaces (11, 12) is greater than the opposite distance between the first and second contact surfaces (11 and 12).

5. Heat transfer device according to one of the previous claims
**characterized in that**
the semiconductor component (10) is a laser diode bar which contains at least one optical axis of radiation emission, and
the dimension of at least one of the heat conducting bodies (20, 30) on at least a straight line which lies perpendicular to at least one of the contact surfaces (11, 12) of the laser diode bar in at least one plane which extends perpendicular to at least one of the contact surfaces (11, 12) of the laser diode bar (10) and parallel to the optical axis of radiation emission through the said heat conducting bodies (20, 30) and the laser diode bar (10), is greater than at least one extension of the laser diode bar (10) lying in the said plane and being aligned parallel to at least one of the contact surfaces (11, 12).

6. Heat transfer device according to claim 5
**characterized in that**
at least one extension of the joining zone (50) in the said plane is at least twice as great as the at least one extension of the laser diode bar (10) lying in the said plane and being aligned parallel to at least one of the contact surfaces (11, 12).

7. Heat transfer device according to one of the previous claims
**characterized in that**
the support sections (27, 37) provide support surfaces (23, 33) on which the spacer (60) rests and for resting on the spacer (60), and/or **characterized in that** the support surface (23, 33) of at least one of the heat conducting bodies (20, 30) lies in a common plane with the heat entry surface (21, 31) of the same heat conducting body (20, 30) apart from a parallel offset which is determined by joining zones (13, 14).

8. Heat transfer device according to one of claims 1 to 7
**characterized in that**
the first and the second heat conducting bodies (20 and 30) each have at least one surface recess, sections at least of which are arranged in the heat entry section (25, 35), the base surface of said surface recess at least sectionally forms the heat entry surface (21, 31) and sections at least of which house the semiconductor component (10), as well as
in each case at least one surface recess, sections at least of which are arranged in the support section (27, 37), the base surface of said surface recess at least sectionally forms the support surface (23, 33), wherein the first and the second heat transfer sections (26 and 36) are arranged at least partly between the planes in which the first and second contact surfaces (11 and 12) of the semiconductor component (10) lie, and/or **characterized in that**
the first heat transfer section (26) has at least first metallic region which is electrically connected to the first contact surface (11) of the semiconductor component (10), the second heat transfer section (26) has at least a second metallic region which is electrically connected to the second contact surface (11) of the semiconductor component (10), and sections at least of the third joining zone (50) have an electrically insulating joining agent which, in at least a part region of the joining gap, bridges at least half of the gap there between the first and second metallic regions by adhesion.

9. Heat transfer device according to one of the previous claims,
**characterized in that**
the first and the second heat conducting bodies (20 and 30) consist predominantly of copper and/ or a carbon-metal composite.

10. Method for assembling a semiconductor component (10), in particular a laser or light-emitting diode element,
**characterized by** the following method steps:
a)
introduction of at least sections of the semiconductor component (10),
which has
- on a first side, at least a first contact surface (11), sections at least of which are substantially flat and
- on at least a second side facing away from the first side, at least a second contact surface (12), sections at least of which are substantially flat,
between a first and a second heat conducting body (20 and 30),
such that
- sections at least of the first contact surface (11) lie opposite a first heat entry surface (21) of a first heat absorbing section (25) of the first heat conducting body (20) in a direction facing away from the semiconductor component (10), and
- sections at least of the second contact surface (12) lie opposite a second heat entry surface (31) of a second heat absorbing section (35) of the second heat conducting body (30) in a direction facing away from the semiconductor component (10),
b)
connection by adhesion of the first heat absorbing section (25) to the semiconductor component (10) with formation of a first joining zone (13) inside an adhesion bond which extends in the line, oriented perpendicular to the first contact surface, of the semiconductor component (10) from the first contact surface (11) to the first heat entry surface (21),
c)
connection by adhesion of the second heat absorbing section (35) to the semiconductor component (10) with formation of a second joining zone (14) inside an adhesion bond which extends in the line, oriented perpendicular to the second contact surface (12), of the semiconductor component from the second contact surface (12) to the second heat entry surface (31),
d)
connection by adhesion of opposing regions of a first heat transfer section (26) of the first heat conducting body (20) sections at least of which extend beyond the semiconductor component (10) in at least a first heat transfer direction parallel to the first contact surface (11),
and
of a second heat transfer section (36) of the heat conducting body (30) sections at least of which extend beyond the semiconductor component (10) in at least a second heat transfer direction parallel to the second contact surface (12),
with formation of a third joining zone (50) sections at least of which have a greater thickness than the first or the second joining zone
and
e)
exertion of at least a compressive force during at least one of the method steps b), c) and d) by one support section (27, 37) on another support section (37, 27) of the heat conducting bodies /20 and 30) via a spacer (60),
sections at least of which are arranged in a support position between opposing regions of a first support section (27) of the first heat conducting body (20) which adjoins the first heat transfer section (26),
and
of a second support section (37) of the second heat conducting body (30) which adjoins the second heat transfer section (36).

11. Method for assembling a semiconductor component according to claim 10
**characterized in that**
the method steps b) and d) or the method steps c) and d) take place at least at times in a common connection process, wherein the thickness of sections at least of the third joining zone (50) is greater than the thickness of whichever of the first or second joining zones (13 or 14) is formed at least at times jointly with the third joining zone (50), and/or **characterized in that**
the method steps b), c) and d) take place at least at times in a common connection process, wherein the thickness of sections at least of the third joining zone (50) is greater than the sum of the thicknesses of the first and second joining zones (13 and 14).

12. Method for assembling a semiconductor component according to claim 10 or 11,
**characterized in that**
in preparation for the method step d) an electrically insulating joining agent is introduced between the heat transfer sections (26 and 36) of the two heat conducting bodies (20 and 30).

13. Method for assembling a semiconductor component according to one of claims 10 to 12
**characterized in that**
in preparation for method step e) the spacer (60) is introduced between the support sections (27, 37) of the heat conducting bodies (20, 30) and during method step e) rests in the support position on a pressure-receiving support surface (23, 33) of the support section (27, 37)
and a pressure-exerting support surface (33, 23) of the other support section (37, 27) rests on the spacer (60), and/or **characterized in that**
the spacer (60) is electrically conductive and in its support position electrically connects a first metallic region, which is electrically connected to the first contact surface (11) of the semiconductor component (10), to a second metallic region which is electrically connected to the second contact surface of the semiconductor component, when in particular
the first heat conducting body (20) contains the first metallic region and the second heat conducting body (30) the second metallic region.

14. Method for assembling a semiconductor component according to claim 13
**characterized in that**
the spacer (60) is removed from its support position in order to operate the semiconductor component (10).

15. Method for assembling a semiconductor component according to one of claims 10 to 14
**characterized in that**
in order to operate the semiconductor component (10), at least one of the heat conducting bodies (20 or 30) on a side facing away from the semiconductor component (10) is connected to at least one heat sink.

## Revendications

1. Dispositif de transfert thermique, comprenant :
- au moins un composant semi-conducteur (10), en particulier un élément de diode laser ou électroluminescente,
- un premier corps thermoconducteur (20),
- au moins un deuxième corps thermoconducteur (30),
dans lequel
le composant semi-conducteur (10)
- présente sur une première face au moins une première surface de contact (11) substantiellement plane au moins par endroits, et
- présente sur au moins une deuxième face détournée de la première face au moins une deuxième surface de contact (12) substantiellement plane au moins par endroits, et
- est disposé au moins par endroits entre le premier et le deuxième corps thermoconducteur (20 et 30),
le premier corps thermoconducteur (20)
- présente au moins une portion d'absorption de chaleur (25) avec au moins une première surface d'entrée de chaleur (21) qui est opposée au moins par endroits à la première surface de contact (11) dans une direction détournée du composant semi-conducteur (10) et qui est reliée au composant semi-conducteur (10) par au moins un contact de matière s'étendant dans l'alignement orienté perpendiculairement à la première surface de contact (11) du composant semi-conducteur (10), de la première surface de contact (11) à la première surface d'entrée de chaleur (21), et présentant au moins une première zone de jonction (13),
et
- au moins une première portion de transfert thermique (26) qui s'étend dans au moins une première direction de transfert thermique au moins par endroits en parallèle à la première surface de contact (11) au-delà du composant semi-conducteur (10),
le deuxième corps thermoconducteur (30)
- présente au moins une deuxième portion d'absorption de chaleur (35) avec au moins une deuxième surface d'entrée de chaleur (31), qui est opposée au moins par endroits à la deuxième surface de contact (12) dans une direction détournée du composant semi-conducteur (10), et qui est reliée au composant semi-conducteur (10) par au moins un contact de matière s'étendant dans l'alignement orienté perpendiculairement à la deuxième surface de contact (12) du composant semi-conducteur (10), de la deuxième surface de contact (12) à la deuxième surface d'entrée de chaleur (31), et présentant au moins une deuxième zone de jonction (14),
et
- au moins une deuxième portion de transfert thermique (36) qui s'étend dans au moins une deuxième direction de transfert thermique, parallèle à la première direction de transfert thermique, au moins par endroits en parallèle à la deuxième surface de contact (12) au-delà du composant semi-conducteur (10), et qui est opposée au moins par endroits à la première portion de transfert thermique (26) du premier corps thermoconducteur (20),
dans lequel
- les portions de transfert thermique (26 et 36) du premier et deuxième corps thermoconducteur (20 et 30) sont reliées ensemble par contact de matière par l'intermédiaire d'une jointure disposée au moins par endroits entre des zones mutuellement opposées des portions de transfert thermique, et présentant au moins une troisième zone de jonction (50),
**caractérisé en ce que**
le premier corps thermoconducteur (20)
- présente au moins une première portion d'appui (27) adjacente à la première portion de transfert thermique (26),
le deuxième corps thermoconducteur (30)
- présente au moins une portion d'appui (37) adjacente à la deuxième portion de transfert thermique (36) et opposée au moins par endroits à la première portion d'appui (27),
- au moins une pièce d'écartement (60) est disposée entre des zones mutuellement opposées des deux portions d'appui (27 et 37),
- et la troisième zone de jonction (50) présente au moins par endroits une plus grande épaisseur que la première ou la deuxième zone de jonction (13 et 14).

2. Dispositif de transfert thermique selon la revendication 1, **caractérisé en ce que** la pièce d'écartement (60) est un corps individuel et peut donc être identifiée comme un composant distinct des corps thermoconducteurs, ou **caractérisé en ce que** la pièce d'écartement (60) est un composant intégré ou intégral d'au moins l'un des corps thermoconducteurs (20, 30).

3. Dispositif de transfert thermique selon l'une quelconque des revendications précédentes, **caractérisé en ce que** la pièce d'écartement (60) est disposée au moins en partie entre les plans où se situent la première et la deuxième surface de contact (11 et 12) du composant semi-conducteur (10), et/ou **caractérisé en ce que** la pièce d'écartement (60) est diélectrique.

4. Dispositif de transfert thermique selon l'une quelconque des revendications précédentes, **caractérisé en ce que** l'épaisseur de la pièce d'écartement (60) dévie de moins de 50 % par rapport à l'écartement mutuel des première et deuxième surfaces de contact (11 et 12) dans une direction perpendiculaire à au moins l'une des surfaces de contact (11, 12), et/ou **caractérisé en ce que** l'épaisseur de la pièce d'écartement (60) est supérieure à l'écartement mutuel des première et deuxième surfaces de contact (11 et 12) dans une direction perpendiculaire à au moins l'une des surfaces de contact (11, 12).

5. Dispositif de transfert thermique selon l'une quelconque des revendications précédentes, **caractérisé en ce que** le composant semi-conducteur (10) est une barrette de diodes laser qui présente au moins un axe optique de l'émission de rayonnement, et
**en ce que** l'extension d'au moins d'un des corps thermoconducteurs (20, 30) sur au moins une droite, qui est perpendiculaire à au moins l'une des surfaces de contact (11, 12) de la barrette de diodes laser dans au moins un plan qui s'étend perpendiculairement à au moins l'une des surfaces de contact (11, 12) de la barrette de diodes laser (10) et en parallèle à l'axe optique de l'émission de rayonnement à travers ledit corps thermoconducteur (20, 30) et la barrette de diodes laser (10), est supérieure à au moins une extension de la barrette de diodes laser (10) située dans ledit plan et alignée en parallèle à au moins l'une des surfaces de contact (11, 12).

6. Dispositif de transfert thermique selon la revendication 5, **caractérisé en ce qu'**au moins une extension de la zone de jonction (50) dans ledit plan est au moins deux fois plus grande que ladite au moins une extension située de la barrette de diodes laser (10) dans ledit plan, qui est alignée en parallèle à au moins l'une des surfaces de contact (11, 12).

7. Dispositif de transfert thermique selon l'une quelconque des revendications précédentes, **caractérisé en ce que** les portions d'appui (27, 37) prévoient des surfaces d'appui (23, 33) pour l'appui de la pièce d'écartement (60) et pour l'appui sur la pièce d'écartement (60), et/ou **caractérisé en ce que** la surface d'appui (23, 33) d'au moins l'un des corps thermoconducteurs (20, 30) est située dans un plan commun avec la surface d'entrée de chaleur (21, 31) du même corps thermoconducteur (20, 30) excepté un décalage parallèle dû à la zone de jonction (13, 14).

8. Dispositif de transfert thermique selon l'une quelconque des revendications 1 à 7, **caractérisé en ce que** le premier et le deuxième corps thermoconducteur (20 et 30) présentent respectivement au moins un évidement superficiel disposé au moins par endroits dans la portion d'entrée de chaleur (25, 35) et dont la surface de fond constitue la surface d'entrée de chaleur (21, 31) au moins par endroits et qui reçoit le composant semi-conducteur (10) au moins par endroits, et
**en ce qu'**il présente au moins un évidement superficiel disposé au moins par endroits dans la portion d'appui (27, 37) et dont la surface de fond constitue la surface d'appui (23, 33) au moins par endroits, la première et la deuxième portion de transfert thermique (26 et 36) étant disposées au moins en partie entre les plans où se situent les première et deuxième surfaces de contact (11 et 12) du composant semi-conducteur (10), et/ ou
**caractérisé en ce que** la première portion de transfert thermique (26) présente au moins une première zone métallique qui se trouve en communication électrique avec la première surface de contact (11) du composant semi-conducteur (10),
**en ce que** la deuxième portion de transfert thermique (26) présente au moins une deuxième zone métallique qui se trouve en communication électrique avec la deuxième surface de contact (11) du composant semi-conducteur (10), et
**en ce que** la troisième zone de jonction (50) présente au moins par endroits un moyen de jonction diélectrique qui, dans au moins une zone partielle de la jointure, comble par contact de matière au moins la moitié de l'écartement à cet endroit entre la première et la deuxième zone métallique.

9. Dispositif de transfert thermique selon l'une quelconque des revendications précédentes, **caractérisé en ce que** le premier et le deuxième corps thermoconducteur (20 et 30) sont composés principalement de cuivre et/ou d'un matériau composite de carbone et métal.

10. Procédé de montage d'un composant semi-conducteur (10), en particulier d'un élément à diode laser ou électroluminescente, **caractérisé par** les étapes suivantes :
a) introduire au moins par endroits le composant semi-conducteur (10) qui
- présente sur une première face, au moins une première surface de contact (11) substantiellement plane au moins par endroits, et
- présente sur au moins une deuxième face, détournée de la première face, au moins une deuxième surface de contact (12) substantiellement plane au moins par endroits,
entre un premier et un deuxième corps thermoconducteur (20 et 30)
de telle sorte que
- la première surface de contact (11) est opposée au moins par endroits à une première surface d'entrée de chaleur (21) d'une première portion d'absorption de chaleur (25) du premier corps thermoconducteur (20) dans une direction détournée du composant semi-conducteur (10), et
- la deuxième surface de contact (12) est opposée au moins par endroits à une deuxième surface d'entrée de chaleur (31) d'une deuxième portion d'absorption de chaleur (35) du deuxième corps thermoconducteur (30) dans une direction détournée du composant semi-conducteur (10),
b) relier par contact de matière la première portion d'absorption de matière (25) au composant semi-conducteur (10) en réalisant une première zone de jonction (13) à l'intérieur d'un contact de matière qui s'étend dans l'alignement du composant semi-conducteur (10) orienté perpendiculairement à la première surface de contact, de la première surface de contact (11) à la première surface d'entrée de chaleur (21),
c) relier par contact de matière la deuxième portion d'absorption de matière (35) au composant semi-conducteur (10) en réalisant une deuxième zone de jonction (14) à l'intérieur d'un contact de matière qui s'étend dans l'alignement du composant semi-conducteur (10) orienté perpendiculairement à la deuxième surface de contact (12), de la deuxième surface de contact (12) à la deuxième surface d'entrée de chaleur (31),
d) relier par contact de matière des zones mutuellement opposées d'une première portion de transfert thermique (26) du premier corps thermoconducteur (20) qui s'étend dans au moins une première direction de transfert thermique au moins par endroits en parallèle à la première surface de contact (11) au-delà du composant semi-conducteur (10),
et
une deuxième portion de transfert thermique (36) du deuxième corps thermoconducteur (30) qui s'étend dans au moins une deuxième direction de transfert thermique au moins par endroits en parallèle à la deuxième surface de contact (12) au-delà du composant semi-conducteur (10),
en réalisant une troisième zone de jonction (50) qui présente au moins par endroits une épaisseur supérieure à la première ou à la deuxième zone de jonction,
et
e) exercer au moins une force de compression pendant au moins l'une des étapes b), c) et d) d'une portion d'appui (27, 37) à une autre portion d'appui (37, 27) des corps thermoconducteurs (20 et 30) par l'intermédiaire d'une pièce d'écartement (60),
qui est disposée au moins par endroits dans une position d'appui entre des zones mutuellement opposées d'une première portion d'appui (27) du premier corps thermoconducteur (20), adjacente à la première portion de transfert thermique (26), et d'une deuxième portion d'appui (37) du deuxième corps thermoconducteur (30), adjacente à la deuxième portion de transfert thermique (36).

11. Procédé de montage d'un composant semi-conducteur selon la revendication 10, **caractérisé en ce que** les étapes b) et d) ou les étapes c) et d) sont effectuées au moins temporairement dans un processus de connexion commun, dans lequel l'épaisseur de la troisième zone de jonction (50) est supérieure au moins par endroits à l'épaisseur de celle de la première ou deuxième zone de jonction (13 ou 14) qui est formée au moins temporairement en même temps que la troisième zone de jonction (50), et/ou **caractérisé en ce que** les étapes b), c) et d) sont effectuées au moins temporairement dans un processus de connexion commun, dans lequel l'épaisseur de la troisième zone de jonction (50) est supérieure au moins par endroits à la somme des épaisseurs de la première et de la deuxième zone de jonction (13 et 14).

12. Procédé de montage d'un composant semi-conducteur selon la revendication 10 ou 11, **caractérisé en ce qu'**en préparation de l'étape d), un moyen de jonction diélectrique est introduit entre les portions de transfert thermique (26 et 36) des deux corps thermoconducteurs (20 et 30).

13. Procédé de montage d'un composant semi-conducteur selon l'une quelconque des revendications 10 à 12, **caractérisé en ce qu'**en préparation de l'étape e), la pièce d'écartement (60) est introduite entre les portions d'appui (27, 37) des corps thermoconducteurs (20, 30), et s'appuie pendant l'étape e) dans la position d'appui sur une surface d'appui (23, 33) d'absorption de pression de la portion d'appui (27, 37), et une surface d'appui (33, 23) de génération de pression (33, 23) de l'autre portion d'appui (37, 27) s'appuie sur la pièce d'écartement (60), et/ou **caractérisé en ce que** la pièce d'écartement (60) est électriquement conductrice et relie électriquement dans sa position d'appui une première zone métallique, qui se trouve en communication électrique avec la première surface de contact (11) du composant semi-conducteur (10), à une deuxième zone métallique, qui se trouve en communication électrique avec la deuxième surface de contact du composant semi-conducteur, dans lequel de préférence le premier corps thermoconducteur (20) présente la première zone métallique et le deuxième corps thermoconducteur (30) présente la deuxième zone métallique.

14. Procédé de montage d'un composant semi-conducteur selon la revendication 13, **caractérisé en ce que** pour le fonctionnement du composant semi-conducteur (10), la pièce d'écartement (60) est retirée de sa position d'appui.

15. Procédé de montage d'un composant semi-conducteur selon l'une quelconque des revendications 10 à 14, **caractérisé en ce que** pour le fonctionnement du composant semi-conducteur (10), au moins l'un des corps thermoconducteurs (20 ou 30) est connecté à au moins un dissipateur thermique du côté détourné du composant semi-conducteur (10).
